(19) Europäisches Patentamt / European Patent Office / Office européen des brevets

(11) **EP 2 833 401 B1**

(12) **EUROPEAN PATENT SPECIFICATION**

(45) Date of publication and mention of the grant of the patent:
**03.08.2022 Bulletin 2022/31**

(21) Application number: **13770305.4**

(22) Date of filing: **29.03.2013**

(51) International Patent Classification (IPC):
*H01L 23/36* (2006.01)   *H05K 7/20* (2006.01)
*H05K 1/18* (2006.01)   *H05K 1/09* (2006.01)
*H05K 1/02* (2006.01)   *H01L 23/473* (2006.01)
*H01L 23/373* (2006.01)   *C04B 37/02* (2006.01)
*B32B 15/04* (2006.01)   *B32B 15/20* (2006.01)
*H01L 23/40* (2006.01)   *B32B 9/00* (2006.01)
*B32B 9/04* (2006.01)   *H05K 1/03* (2006.01)

(52) Cooperative Patent Classification (CPC):
**B32B 9/005; B32B 9/041; B32B 15/043;**
**B32B 15/20; C04B 37/026; H01L 23/3735;**
**H05K 1/0209; H05K 1/0306;** B32B 2255/06;
B32B 2255/205; B32B 2307/302; B32B 2307/51;
B32B 2307/54; B32B 2457/14; C04B 2235/72;

(Cont.)

(86) International application number:
**PCT/JP2013/059469**

(87) International publication number:
**WO 2013/147124 (03.10.2013 Gazette 2013/40)**

(54) **POWER MODULE SUBSTRATE WITH HEAT SINK, POWER MODULE SUBSTRATE WITH COOLER, AND POWER MODULE**

LEISTUNGSMODULSUBSTRAT MIT KÜHLKÖRPER, LEISTUNGSMODULSUBSTRAT MIT KÜHLER UND LEISTUNGSMODUL

SUBSTRAT DE MODULE DE PUISSANCE MUNI DE DISSIPATEUR THERMIQUE, SUBSTRAT DE MODULE DE PUISSANCE MUNI DE REFROIDISSEUR, ET MODULE DE PUISSANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.03.2012 JP 2012082997**

(43) Date of publication of application:
**04.02.2015 Bulletin 2015/06**

(73) Proprietor: **Mitsubishi Materials Corporation**
**Chiyoda-ku**
**Tokyo 100-8117 (JP)**

(72) Inventors:
• **NAGATOMO Yoshiyuki**
  **Kitamoto-shi**
  **Saitama 364-0022 (JP)**
• **KUROMITSU Yoshirou**
  **Naka-shi**
  **Ibaraki 311-0102 (JP)**

(74) Representative: **Hoffmann Eitle**
**Patent- und Rechtsanwälte PartmbB**
**Arabellastraße 30**
**81925 München (DE)**

(56) References cited:
**EP-A1- 1 926 142**   **JP-A- 2006 019 410**
**JP-A- 2006 202 884**   **JP-A- 2007 081 202**
**JP-A- 2007 250 638**   **JP-A- 2007 250 638**
**JP-A- 2009 065 144**   **JP-A- 2009 065 144**
**JP-A- 2009 283 741**   **US-A1- 2006 157 862**
**US-A1- 2009 289 344**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
C04B 2235/96; C04B 2237/121; C04B 2237/128;
C04B 2237/366; C04B 2237/402; C04B 2237/704;
C04B 2237/706; C04B 2237/86; H01L 23/4006;
H01L 23/473; H01L 2224/32225; H05K 2201/066

## Description

Technical Field

The present invention relates to: a power module with a heatsink including a power module substrate and a heatsink, the power module substrate being provided with a circuit layer arranged on a surface of a ceramic substrate and a metal layer arranged on the other surface of the ceramics substrate and formed of aluminum, and the heatsink being composed of copper or a copper alloy; a power module with a cooler including the power module substrate with a heatsink; and a power module.

Background Art

Among semiconductor devices, power devices for supplying power have a relatively large amount of heat generation. Therefore, as a substrate mounted with the power device, for example, as shown in Patent Documents 1 to 4, a power module substrate is widely used in which a metal plate, which is composed of aluminum and used as a circuit layer, is bonded on a surface of a ceramic substrate, and another metal plate, which is composed of aluminum and used as a metal layer, is bonded on the other surface of the ceramic substrate.

In these power module substrates, a heat radiation plate (heatsink) made of copper is bonded on the metal layer on the side opposite to the ceramics substrate via a soldering layer. In addition, the heatsink is fixed to a cooler by a screw or the like.

Heat cycle is performed on the power module described above during the use thereof. Here, when heat cycle is performed on the power module substrate, strain is accumulated in a solder layer interposed between the heat radiation plate (heatsink) and the metal layer, and cracks may be generated in the solder layer.

Conventionally, by forming the metal layer of aluminum having a relatively low deformation resistance such as 4N aluminum in which the content of aluminum is 99.99% by mass or more, the strain described above is absorbed by the deformation of the metal layer, and the generation of cracks in the solder layer is prevented.

According to the result of calculation of strain distribution in the solder layer interposed between the metal layer formed of 4N aluminum and the heat radiation plate (heatsink) composed of copper, the strain is distributed throughout the metal layer, the strain is widely distributed, and the peak value of the amount of strain is reduced.

[Prior Art Documents]

[Patent Documents]

[Patent Document 1] Japanese Unexamined Patent Application, First Publication No. 2004-152969
[Patent Document 2] Japanese Unexamined Patent Application, First Publication No. 2004-153075
[Patent Document 3] Japanese Unexamined Patent Application, First Publication No. 2004-200369
[Patent Document 4] Japanese Unexamined Patent Application, First Publication No. 2004-207619

Further related prior art is found in EP 1 926 142 A1 describing an insulating circuit board with cooling sink.

DISCLOSURE OF THE INVENTION

Problems to be Solved by the Invention

As described above, when the metal layer is formed of aluminum having a relatively low deformation resistance such as 4N aluminum, there is a possibility that cracks are generated in a wide range in the solder layer, bonding between the metal layer and the heatsink becomes insufficient, and the thermal resistance rises after heat cycle is performed. This can be presumed because the metal layer is deformed more than necessary when heat cycle is performed, strain is further applied to the solder layer interposed between the metal layer and the heatsink, and in spite of the wide distribution of strain, the amount of strain cannot be sufficiently reduced.

In particular, recently, since miniaturization and thinning of the power module are promoted, the usage environment thereof has intensified and the amount of heat generation from electronic components such as semiconductor devices becomes large, the temperature difference of heat cycle is large, and cracks tend to be generated easily in a wide range in the solder layer.

In addition, as the solder layer interposed between the metal layer and the heatsink, recently, for example, Sn-Ag-based or Sn-Ag-Cu-based lead-free solder materials are used. These solder materials are the precipitation hardening type solder materials which are hardened by dispersing precipitates containing Sn-Ag intermetallic compound in a matrix of Sn. The solder layer containing such solder materials has a problem in that the strength of the solder layer becomes thermally unstable, because the particle size and dispersion state of the precipitates are changed by the heat cycle.

The present invention is defined by the appended independent claim. The dependent claims describe optional features and preferred embodiments.

The present invention has been made in view of the above circumstances, and the present invention provides a power module substrate with a heatsink which can suppress the generation and progress of cracks in a solder layer interposed between a metal layer formed of aluminum and a heatsink composed of copper and which is excellent in bonding reliability; a power module substrate with a cooler including the power module substrate with a heatsink; and a power module.

Means for Solving the Problem

In order to solve the above mentioned problems, as a result of diligent research by the inventors, they found that by using an aluminum plate in which purity of aluminum is 99.0 to 99.85% by mass (so-called 2N aluminum) in the metal layer, it is possible to suppress the deformation of the metal layer as compared with the case of using an aluminum plate of 4N aluminum. In addition, according to the results of calculation of the strain distribution inside the solder layer interposed between the metal layer formed of 2N aluminum and the heatsink composed of copper, they found that the amount of strain is high at the periphery of the metal layer and the amount of strain is low in the inner region of the metal layer.

The present invention is based on the above findings. An assembly of the present invention is defined in claim 1.

According to the power module substrate with a heatsink of this configuration, since the metal layer is formed by bonding the aluminum plate in which the content of Al is 99.0 to 99.85% by mass to the ceramic substrate, the metal layer is difficult to deform after the heat cycle is performed, and the generation of cracks in the solder layer can be prevented. On the other hand, when the content of A1 is less than 99.0% by mass, plastic deformation of A1 is insufficient, and thus, sufficient effects of stress buffering cannot be obtained. As a result, the junction rate is reduced after heat cycle due to generation of cracks in the ceramic and the solder layer. In addition, when the content thereof exceeds 99.85% by mass, cracks are generated in the solder layer from the deformation of the metal layer after heat cycle is performed, and the junction ratio is lowered. According to these reasons, the content of the Al is set in the range of 99.0 to 99.85% by mass.

In addition, since the solder layer is formed of the solid-solubilized-hardening type solder material which includes Sn as a major component and solid-solubilized elements being solid-solubilized into the matrix of Sn, the strength of the matrix of the solder material is increased. In addition, the strength is secured even when heat cycle is performed. Thus, even when cracks are generated in the solder layer in the periphery of the metal layer, the cracks can be suppressed from progressing to the inner region of the metal layer.

In addition, the content of A1 is 99.0 to 99.85% by mass in aluminum plate forming the metal layer, and Fe, Cu, and Si are included as major impurities.

The solder layer is formed of a solder material containing Sb as the solid-solubilized element.

In this case, by solid-solubilizing Sb in the matrix of Sn, strength of the solder layer can be reliably improved and be thermally stable. Thus, it is possible to reliably suppress the progress of cracks generated in the peripheral of the metal layer. In addition, since the strength is increased sufficiently by solid-solubilizing Sb in Sn, it may contain other elements for generating precipitates. That is, even if the particle size and the dispersion state of the precipitates are changed, the strength of the matrix of Sn can be secured by solid-solubilized-hardening of Sb and the progress of cracks can be suppressed.

Furthermore, the heatsink is composed of copper or a copper alloy having a tensile strength of 250 MPa or more.

In this case, since the heatsink is not easily plastically deformed, the heatsink deforms in the elastic deformation region. Therefore, the plastic deformation which causes warpage can be prevented in the heatsink, and the heatsink can be arranged to be laminated in close contact to the cooler.

In addition, as the heatsink, metal parts such as a heat radiation plate having a plate shape, a cooler in which cooling medium flows therethrough, a liquid-cooled or air-cooled heat radiation unit with fins, and heat pipe, are included to reduce temperature by radiating heat.

The power module substrate with a cooler according to the present invention includes the power module substrate with a heatsink and a cooler laminated on the other surface side of the heatsink.

According to the power module substrate with a cooler having this configuration, since the heatsink made of copper excellent in thermal conductivity is provided thereto, heat from the power module substrate can be effectively spread and dispersed. Further, generation and progress of cracks are suppressed in the solder layer interposed between the metal layer and the cooler, heat from the side of the power module substrate can reliably conduct to the cooler.

A power module according to the present invention includes the power module substrate with a heatsink and electronic parts mounted on the power module substrate with a heatsink.

According to the power module having this configuration, since generation and progress of cracks are suppressed in the solder layer interposed between the metal layer and the cooler, the reliability thereof can tremendously improve.

Effects of the Invention

The present invention can provide a power module substrate with a heatsink which can suppress the generation and progress of cracks in a solder layer interposed between a metal layer formed of aluminum and a heatsink composed of copper and which is excellent in bonding reliability; a power module substrate with a cooler including the power module substrate with a heatsink; and a power module.

BRIEF DESCRIPTION OF THE DRAWINGS

FIG. 1 is a schematic explanatory diagram of a power module according to an embodiment of the present invention.
FIG. 2 is an explanatory diagram showing the power module substrate with a heatsink according to the embodiment of the present invention.
FIG. 3 is an explanatory diagram showing the method for producing the power module substrate with a heatsink according to the embodiment of the present invention.

EMBODIMENTS OF THE INVENTION

Embodiments of the present invention will be explained below with reference to the accompanying drawings.

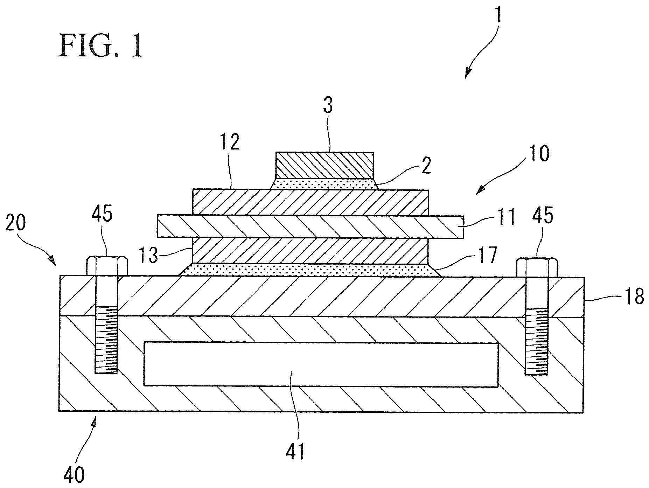

FIG. 1 shows a power module substrate with a heatsink and a power module according to an embodiment of the present invention.

The power module 1 includes the assembly (20) comprising a power module substrate and a heatsink, a semiconductor chip 3, and a cooler 40. The assembly 20 includes a power module substrate 10 provided with a circuit layer 12 and a metal layer 13, and a heat radiation plate 18 is bonded to the surface (a lower surface in FIG. 1) of the metal plate 13 via a solder layer 17. The semiconductor chip 3 is bonded to a surface (an upper surface in FIG. 1) of the circuit layer 12 via a solder layer 2 for the chip. The cooler 40 is provided to the other surface side of the heat radiation plate 18.

In the present embodiment, a heat radiation plate 18 is used as a heatsink.

Here, the solder layer 2 for the chip uses for example, Sn-Ag-based, Sn-In-based, or Sn-Ag-Cu-based solder materials. In addition, in the present embodiment, a Ni plated layer (not shown) is provided between the circuit layer 12 and the solder layer 2 for the chip.

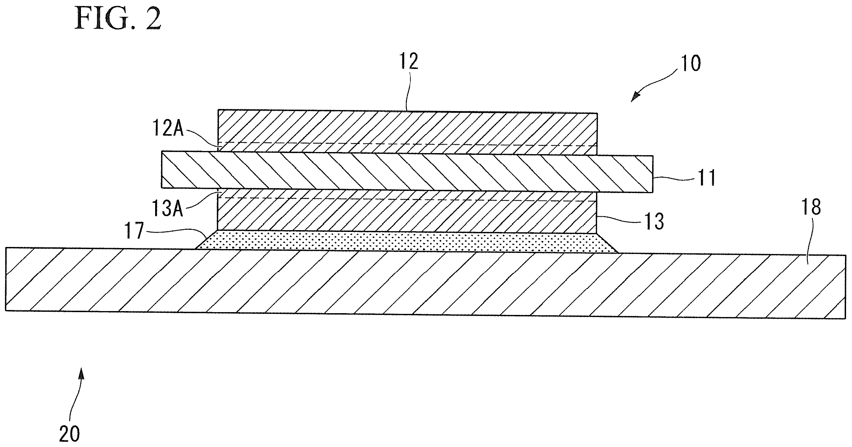

As shown in FIG. 1 and FIG. 2, the power module substrate 10 includes; a ceramic substrate 11 forming an insulation layer, the circuit layer 12 arranged on a surface (upper surface in FIG. 2) of the ceramic substrate 11, and a metal layer 13 arranged on the other surface (lower surface in FIG. 2) of the ceramic substrate 11. That is, the ceramic substrate 11 has a first surface (a surface) and a second surface (the other surface), the circuit layer is arranged on the first surface of the ceramic substrate 11, and the metal layer is arranged on the second surface of the ceramic substrate 11.

The ceramic substrate 11 is for preventing electric connection between the circuit layer 12 and the metal layer 13, and is composed of AlN (aluminum nitride) having high insulation properties. The thickness of the ceramic substrate 11 is set to 0.2 to 1.5 mm, and the thickness thereof in the present embodiment is set to 0.635 mm. In the present embodiment, as shown in FIG. 1 and FIG. 2, the width of the ceramic substrate 11 is wider than the width of the circuit layer 12 and the metal layer 13.

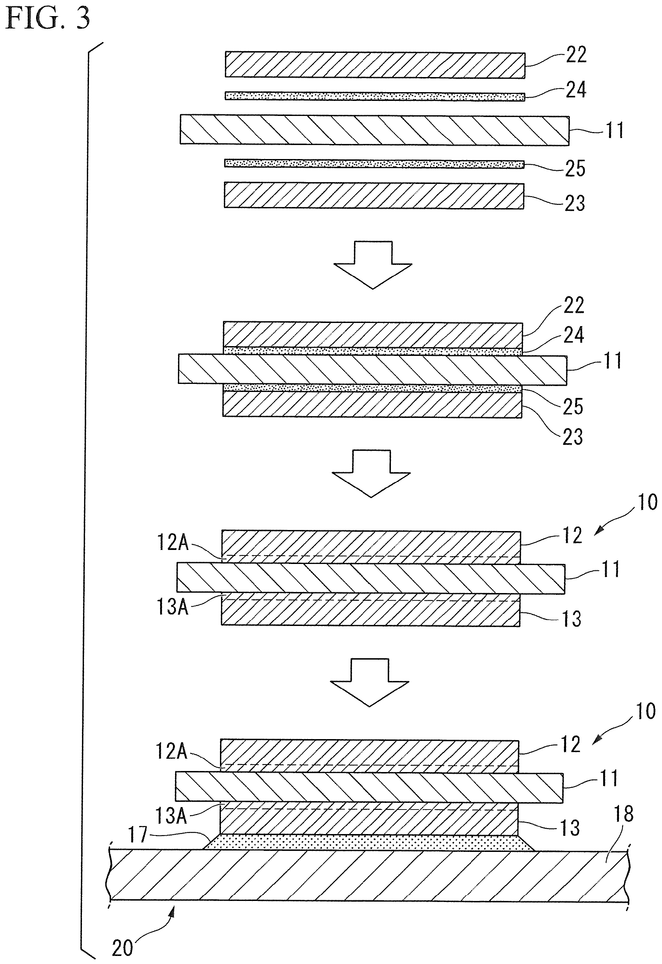

As shown in FIG. 3, the circuit layer 12 is formed by bonding a metal plate 22 having electrical conductivity on the first surface (upper surface in FIG. 3) of the ceramic substrate 11. In the present embodiment, the circuit layer 12 is formed by bonding the metal plate 22 made of an aluminum rolled sheet in which the content of aluminum is 99.99% by mass or more (so-called 4N aluminum), to the ceramic substrate 11.

In addition, as described later, the metal plate 22 and the ceramic substrate 11 are bonded via Al-Si-based solder material. Thus, in the vicinity of an interface in the circuit layer 12 between the ceramic substrate 11 and the circuit layer 12, the interface vicinity layer 12A in which Si is diffused is formed. In the interface vicinity layer 12A, there is a case that the content of aluminum becomes less than 99.99% by mass.

As shown in FIG. 3, the metal layer 13 is formed by bonding a metal plate 23 on the second surface (lower surface in FIG. 3) of the ceramic substrate 11.

In the present embodiment, the metal layer 13 is formed by bonding a metal plate 23 made of a rolled sheet in which the content of aluminum is 99.0 to 99.85% by mass (so-called 2N aluminum) to the ceramic substrate 11.

In addition, as described later, the metal plate 23 and the ceramic substrate 11 are bonded via Al-Si-based solder material. Thus, in the vicinity of an interface in the metal layer 13 between the ceramic substrate 11 and the metal layer 13, the interface vicinity layer 13A in which Si is diffused is formed. In the interface vicinity layer 13A, there is a case that the content of aluminum becomes less than 99.0% by mass.

The heat radiation plate 18 spreads heat from the power module substrate 10 described above in the surface direction, and composed of copper or a copper alloy excellent in thermal conductivity.

Z In the present invention, the heat radiation plate 18 is composed of copper or a copper alloy having a Young's modulus of 130 GPa or less and a tensile strength of 250 MPa or more. Specifically, the heat radiation plate 18 contains Cu-0.04% by mass of Ni- 0.17% by mass of Co- 0.05% by mass of P- 0.1% by mass of Sn (Cu-Ni-Co-P-Sn; CDANo. C18620), and the Young's modulus thereof is 125 GPa and the tensile strength thereof is 250 MPa or more.

As shown in FIG. 1, the cooler 40 includes a flow passages 41 for which a cooling medium (for example, cooling water) flows. The cooler 40 is preferred to be configured by materials excellent in thermal conductivity, and the present embodiment is configured by A6063 (aluminum alloy).

Here, as shown in FIG. 1, the cooler 40 and the heat radiation plate 18 are fastened together with a fixing screw 45.

The solder layer 17 interposed between the metal layer 13 and the heat radiation layer 18 is formed of a solid-solubilized-hardening type solder material including Sn as a major component and a solid-solubilized element being solid-solubilized into the matrix of Sn. In the present embodiment, the solder material is Sn-Sb-based alloy containing Sb in a range of 2 to 5% by mass as a solid-solubilized element, and specifically the solder material is a Sn- 5% by mass of Sb solder material.

In addition, in the present embodiment, a Ni plating layer (not shown) is provided between the metal layer 13 and the solder layer 17.

A method for producing the assembly 20 having the above-described configuration is explained below with reference to FIG. 3.

First, as shown in FIG. 3, the metal plate 22 (a rolled sheet composed of 4N aluminum) serving as the circuit layer 12 is laminated on the first surface side of the ceramic substrate 11 via a brazing filler metal foil 24 having 5 to 50 $\mu$m in thickness (14 $\mu$m in this present invention).

In addition, the metal plate 23 (a rolled sheet composed of 2N aluminum) serving as the metal layer 13 is laminated on the second surface side of the ceramic substrate 11 via a brazing filler metal foil 25 having 5 to 50 $\mu$m in thickness (14 $\mu$m in this present invention).

Here, in the present embodiment, the brazing filler metal foils 24 and 25 are the Al-Si-based brazing filler metal including Si which is a melting point lowering element.

Subsequently, the metal plate 22 laminated as described above, the brazing filler metal foil 24, the ceramic substrate 11, the brazing filler metal foil 25, and the metal plate 23 are charged into a heating furnace and heated in a pressed state in the lamination direction (with a pressure of 98 to 490 kPa (1 to 5 kgf/cm$^2$)). Part of each of the brazing filler metal foils 24, 25 and the metal plates 22, 23 is melted, and molten metal areas are formed in each of the interfaces between the metal plates 22, 23 and the ceramic substrate 11. Here, the heating temperature is 550 to 650 °C, and the heating duration is 30 to 180 minutes. Then, by cooling it after heating, the molten metal areas formed in each of the interfaces between the metal plates 22, 23 and the ceramic substrate 11 are solidified, and the ceramic substrate 11 and the metal plates 22, 23 are bonded.

At this time, the melting point lowering element (Si) in the brazing filler metal foil 24 and 25 are diffused to the metal plates 22 and 23.

In the above-described manner, the metal plates 22 and 23 serving, respectively, as the circuit layer 12 and the metal layer 13, and the ceramic substrate 11 are bonded. Accordingly, the power module substrate 10 according to the present embodiment is produced.

In addition, in the metal layer 13, the interface vicinity layer 13A is formed by the diffusion of Si included in the brazing filler metal foil 25. In a similar way, in the circuit layer 12, the interface vicinity layer 12A is formed by the diffusion of Si included in the brazing filler metal foil 24.

Subsequently, after forming a Ni plating film on the other surface of the metal layer 13 of the power module substrate 10, the heatsink 18 is soldered joint by using a Sn-5% by mass Sb solder material. In this way, the solder layer 17 is formed between the metal layer 13 and the heatsink 18, and the assembly 20 according to the present embodiment is produced.

Then, the heat radiation plate 18 of the assembly 20 is fastened to the cooler 40 with a fixing screw 45. In this way, the power module substrate with a cooler according to the present embodiment is produced.

In addition, the semiconductor chip 3 is mounted on one of the surfaces of the circuit layer 12 via the solder layer 2 for the chip. In this way, the power module 1 according to the present embodiment is produced.

In the power module substrate with a heatsink 20 and the power module 1 according to the present embodiment configured as above, since the metal layer 13 is formed by bonding the metal plate 23 composed of 2N aluminum in which the content of Al is 99.0 to 99.85% by mass to the ceramic substrate 11, the metal layer 13 does not easily deform after the heat cycle is performed, and the generation of cracks in the solder layer 17 can be prevented.

In addition, since the solder layer 17 is formed of a solid-solubilized-hardening type solder material which includes Sn as a major component and a solid-solubilized element being solid-solubilized into the matrix of Sn, and in the present invention, since the solder material is Sn-Sb-based alloy containing Sb in a range of 2 to 5% by mass as a solid-solubilized element, and specifically the solder material is formed of a Sn- 5% by mass of Sb solder material, the strength of the matrix of the solder material 17 is increased and the strength of the matrix of the solder material 17 can be secured even when heat cycle is performed. Therefore, even when cracks are generated in the solder layer 17 in the periphery of the metal layer 13, the cracks can be suppressed from progressing to the inner region of the metal layer 13.

When the content of Sb is less than 2% by mass, effects of the solid-solubilized-hardening may be insufficient, and when the content of Sb exceeds 10% by mass, the solder layer 17 may be too hard. Thus Sb is contained as the solid-solubilized element with a content of 2 to 5% by mass.

In addition, since the heat radiation plate 18 is composed of copper or a copper alloy having a Young's modulus of 130 GPa or less and a tensile strength of 250 MPa or more, the heat radiation plate 18 is ease to elastically deform and is difficult to plastically deform. That is, the elastic deformation region of the heat radiation plate 18 becomes wide. Therefore, by the elastically deformation of the heat radiation plate 18, strain occurring in the solder layer 17 can be reduced, and cracks generated in the periphery of the metal layer 13 can be suppressed from progressing to the inner region of the metal layer 13.

In addition, since the heat radiation plate 18 is suppressed from plastic deformation which causes warpage, the heat radiation plate 18 can be arranged in close contact to the cooler 40 and the heat of the semiconductor chip 3 can be efficiently dispersed to the cooler 40.

The embodiments of the present invention have been explained above.

For example, as the present embodiment of the present invention, the heat radiation plate is used as a heatsink. However, the heatsink can be directly bonded to the cooler having the configuration shown in FIG. 1, or a liquid-cooled or air-cooled heat radiation unit in which fins are formed, a heat pipe or the like can be used as a heatsink.

In addition, in the present embodiment, it was explained that the metal plate serving as the circuit layer and the metal plate serving as the metal layer are bonded to the ceramic substrate by using the brazing filler metal foil. However, the present embodiment is not limited thereto, and the metal plate serving as the circuit layer and the metal plate serving as the metal layer may be bonded to the ceramic substrate by isothermal diffusion bonding (Transient Liquid Phase Diffusion Bonding).

Furthermore, in the present invention, it was explained that the heatsink is composed of copper or a copper alloy having a Young's modulus of 130 GPa or less and a tensile strength of 250 MPa or more. However, outside of the scope of the invention, the heatsink can be composed of other copper materials or other copper alloy materials.

In addition, in the present embodiment, it was explained that the circuit layer was formed of aluminum. However, the present embodiment is not limited thereto, and the circuit layer can be formed of copper or a copper alloy.

Examples

Next, an explanation is described with respect to the confirmation experiment results performed to confirm the effects of the present invention.

Power module substrates with a heatsink shown in Table 1 were produced, and an initial junction rate and a junction rate after heat cycle were evaluated.

Here, the size of the circuit layer and the metal layer was 37 mm x 37 mm, and the size of the ceramic substrate was 40 mm x 40 mm.

The heat radiation plate was used as a heatsink, the size of the heat radiation plate was 70 mm x 70 mm x 3 mm, and the thickness of the solder layer interposed between the heat radiation plate and the metal layer was 0.4 mm.

The junction rate between the metal layer and the heat radiation plate was obtained by using an ultrasonic flaw detection device and by using the calculation formula shown below. Here, the initial bonding area is a target area of bonding at the time before the bonding, that is, an area of the metal layer. Since the peeled off is indicated by a white part in the bonding part in an ultrasonic flaw detection image, the area of the white part is set as a peeled off area.

$$\text{(Junction rate)} = \{ \text{(Initial bonding area)} - \text{(Peeled off area)} \} / \text{(Initial bonding area)}$$

Here, the junction rate was measured before heat cycle was performed and was measured after heat cycle was performed.

In addition, heat cycle was performed by using a thermal shock testing apparatus TSB-51 manufactured by ESPEC Corporation, the cycles were repeated at -40 °C for 5 minutes and in 125 °C for 5 minutes in liquid phase (Fluorinert) with respect to the samples (power module with a heatsink), and 2000 cycles of heat cycle were performed.

The evaluation results are shown in Table 1.

(*) Example 7 is outside of the scope of the invention.

[Table 1]

| | | Heat radiation plate | | | Power module substrate | | | | | | Solder material | Evaluation result | |
| | | Material CDA No. | Thermal refining treatment | Tensile strength (MPa) | Circuit layer | | Ceramic | | Metal layer | | | Junction rate (%) | |
| | | | | | Material | Thickness | Material | Thickness | Purity of Al | Thickness | | Initially | After heat cycle |
|---|---|---|---|---|---|---|---|---|---|---|---|---|---|
| Examples of present invention | 1 | C18620 | O | 300 | 4N | 0.6 mm | AlN | 0.635 mm | 99.70% | 0.6 mm | Sn-5.0Sb | 92 | 90 |
| | 2 | | 1/4H | 345 | A1050 | 0.6 mm | AlN | 0.635 mm | 99.50% | 0.6 mm | Sn-5.0Sb | 95 | 94 |
| | 3 | | 1/2H | 485 | A1070 | 0.6 mm | AlN | 0.5 mm | 99.50% | 0.6 mm | Sn-5.0Sb | 98 | 95 |
| | 4 | | H | 525 | 4N | 0.6 mm | AlN | 0.5 mm | 99.50% | 0.6 mm | Sn-3.9Ag-0.6Cu-3.0Sb | 93 | 90 |
| | 5 | C10200 | 1/2H | 280 | A1050 | 0.6 mm | AlN | 0.5 mm | 99.10% | 0.6 mm | Sn-3.9Ag-0.6Cu-3.0Sb | 96 | 95 |
| | 6 | | H | 310 | A1100 | 0.6 mm | AlN | 0.635 mm | 99.80% | 0.6 mm | Sn-3.9Ag-0.6Cu-3.0Sb | 96 | 94 |
| | 7 | | * H | 310 | A1050 | 0.6 mm | AlN | 0.5 mm | 99.50% | 0.6 mm | Sn-3.5Ag-0.5Bi-8.0In | 97 | 93 |
| Comparative Examples | 1 | C18620 | 1/2H | 485 | 4N | 0.6 mm | AlN | 0.635 mm | 99.50% | 0.6 mm | Sn-3.0Ag-0.5Cu | 98 | 54 |
| | 2 | | 1/2H | 485 | A1050 | 0.6 mm | AlN | 0.635 mm | 99.99% | 0.6 mm | Sn-3.5Ag | 91 | 45 |
| | 3 | | H | 525 | 4N | 0.6 mm | AlN | 0.5 mm | 99.99% | 0.6 mm | Sn-5.0Sb | 99 | 61 |
| | 4 | | H | 525 | A1050 | 0.6 mm | AlN | 0.635 mm | 98.50% | 0.6 mm | Sn-3.9Ag-0.6Cu-3.0Sb | 97 | 72 |

In the comparative examples 1 and 2 using solder materials other than the solid-solubilized-hardening type solder material, it was confirmed that the junction rate decreased after heat cycle was performed. This is presumed because the strength of the matrix of the solder layer was reduced after heat cycle was performed, and cracks generated in the periphery of the metal layer progressed to the inner region of the metal layer.

In addition, in the comparative example 3 in which the metal layer was formed of 4N aluminum, it was confirmed that the junction rate decreased after heat cycle was performed. This is presumed because cracks were generated in the wide range in the solder layer.

In contrast thereof, in the examples 1 to 6 of the present invention, the junction rate did not decrease after heat cycle was performed. It was confirmed that the bonding reliability between the metal layer and the heatsink was improved by forming the metal layer using aluminum in which the content of A1 is 99.0 to 99.85% by mass and by using the solid-solubilized-hardening type solder layer.

FIELD OF INDUSTRIAL APPLICATION

The present invention can provide a power module substrate with a heatsink which can suppress the generation and progress of cracks in a solder layer interposed between a metal layer formed of aluminum and a heatsink composed of copper and which is excellent in bonding reliability; a power module substrate with cooler including the power module substrate with heatsink; and a power module.

[Description of Reference Signs]

    1: Power module
    3: Semiconductor chip (Electronic parts)
    10: Power module substrate
    11: Ceramic substrate
    13: Metal layer
    17: Solder layer
    18: Heatsink (Heat radiation plate)
    20: Assembly

**Claims**

1. Assembly (20) comprising:

    a power module substrate (10) including a ceramic substrate (11), a circuit layer (12) arranged on a surface of the ceramic substrate, and a metal layer (13) arranged on the other surface of the ceramic substrate and formed of aluminum; and
    a heatsink (18) composed of copper or a copper alloy bonded to the other surface side of the metal layer via a solder layer (17),
    wherein the metal layer is formed by bonding an aluminum plate in which the content of A1 is 99.0 to 99.85% by mass to the ceramic substrate,
    **characterized in that** the solder layer (17) is formed of a solder material that is an Sn-Sb-based alloy including Sn as a major component and an Sb of 2 to 5% by mass, the Sb being solid-solubilized into a matrix of Sn, and the heatsink (18) has a Young's modulus of 130 GPa or less and a tensile strength of 250 MPa or more.

2. The assembly according to claim 1, further comprising
   a cooler (40) laminated on the other surface side of the heatsink.

3. A power module (1) comprising:

    the assembly according to claim 1 or 2; and
    electronic parts (3) mounted on a surface of the circuit layer of the power module substrate, the surface of the circuit layer being opposed to the ceramic substrate.

**Patentansprüche**

1. Baugruppe (20), umfassend:

   ein Leistungsmodulsubstrat (10), das ein Keramiksubstrat (11), eine Schaltungsschicht (12), die auf einer Oberfläche des Keramiksubstrats angeordnet ist, und eine Metallschicht (13), die auf der anderen Oberfläche des Keramiksubstrats angeordnet ist und aus Aluminium gebildet ist, beinhaltet; und
   eine Wärmesenke (18), die aus Kupfer oder einer Kupferlegierung besteht, die an die andere Oberflächenseite der Metallschicht durch eine Lötmittelschicht (17) gebunden ist,
   wobei die Metallschicht durch Binden einer Aluminiumplatte, in der der Gehalt an Al 99,0 bis 99,85 Masseprozent ist, an das Keramiksubstrat gebildet wird,
   **dadurch gekennzeichnet, dass** die Lötmittelschicht (17) aus einem Lötmittelmaterial gebildet ist, das eine Legierung auf Sn-Sb-Basis ist, die Sn als eine Hauptkomponente und ein Sb mit 2 bis 5 Masseprozent beinhaltet, wobei das Sb in eine Matrix von Sn festgelöst ist, und
   die Wärmesenke (18) einen Elastizitätsmodul von 130 GPa oder weniger und eine Zugfestigkeit von 250 MPa oder mehr aufweist.

2. Baugruppe nach Anspruch 1, weiter umfassend
   einen Kühler (40), der auf die andere Oberflächenseite der Wärmesenke laminiert ist.

3. Leistungsmodul (1), umfassend:

   die Baugruppe nach Anspruch 1 oder 2; und
   elektronische Teile (3), die auf einer Oberfläche der Schaltungsschicht des Leistungsmodulsubstrats montiert sind, wobei die Oberfläche der Schaltungsschicht dem Keramiksubstrat gegenüberliegt.

**Revendications**

1. Ensemble (20) comprenant :

   un substrat de module de puissance (10) incluant un substrat en céramique (11), une couche de circuit (12) agencée sur une surface du substrat en céramique, et une couche métallique (13) agencée sur l'autre surface du substrat en céramique et constituée d'aluminium ; et
   un dissipateur thermique (18) constitué de cuivre ou d'un alliage de cuivre lié à l'autre côté de surface de la couche métallique via une couche de soudure (17),
   dans lequel la couche métallique est constituée en soudant une plaque d'aluminium dans laquelle la teneur en Al est de 99,0 à 99,85 % en masse par rapport au substrat en céramique,
   **caractérisé en ce que** la couche de soudure (17) est constituée d'un matériau de soudure qui est un alliage à base de Sn-Sb incluant du Sn en tant que composant principal et un Sb de 2 à 5 % en masse, le Sb étant solubilisé à l'état solide en une matrice de Sn, et
   le dissipateur thermique (18) présente un module de Young de 130 GPa ou moins et une résistance à la traction de 250 MPa ou plus.

2. Ensemble selon la revendication 1, comprenant en outre un refroidisseur (40) stratifié sur l'autre côté de surface du dissipateur thermique.

3. Module de puissance (1) comprenant :

   l'ensemble selon la revendication 1 ou 2 ; et
   des pièces électroniques (3) montées sur une surface de la couche de circuit du substrat de module de puissance, la surface de la couche de circuit étant opposée au substrat en céramique.

FIG. 1

FIG. 2

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004152969 A
- JP 2004153075 A
- JP 2004200369 A
- JP 2004207619 A
- EP 1926142 A1